(19) Europäisches Patentamt
European Patent Office
Office européen des brevets

(11) **EP 2 247 915 B1**

(12) **EUROPÄISCHE PATENTSCHRIFT**

(45) Veröffentlichungstag und Bekanntmachung des Hinweises auf die Patenterteilung:
**18.10.2017 Patentblatt 2017/42**

(21) Anmeldenummer: **09712847.4**

(22) Anmeldetag: **18.02.2009**

(51) Int Cl.:
**G01B 5/00** *(2006.01)*    **G05B 19/401** *(2006.01)*

(86) Internationale Anmeldenummer:
**PCT/EP2009/051935**

(87) Internationale Veröffentlichungsnummer:
**WO 2009/103743 (27.08.2009 Gazette 2009/35)**

(54) **XY-TISCH MIT EINER MESSANORDNUNG ZUR POSITIONSBESTIMMUNG**

XY TABLE WITH A MEASURING ARRANGEMENT FOR POSITION DETERMINATION

TABLE XY COMPRENANT UN SYSTÈME DE MESURE POUR LA DÉTERMINATION DE POSITION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **21.02.2008 DE 102008010284**

(43) Veröffentlichungstag der Anmeldung:
**10.11.2010 Patentblatt 2010/45**

(73) Patentinhaber: **Dr. Johannes Heidenhain GmbH 83301 Traunreut (DE)**

(72) Erfinder: **HOLZAPFEL, Wolfgang 83119 Obing (DE)**

(56) Entgegenhaltungen:
US-A- 4 587 622    US-A- 4 758 720
US-A1- 2003 053 037    US-A1- 2004 178 327

**Beschreibung**

Die Erfindung betrifft einen XY-Tisch mit einer Messanordnung zur Positionsbestimmung zum genauen Positionieren eines vorzugsweise flächigen Werkstücks wie beispielsweise eines Wafers relativ zu einem Werkzeug. Beim Werkzeug kann es sich z.B. um ein Inspektionsmikroskop, einen Elektronenstrahl, eine Belichtungsoptik und andere zur Herstellung von integrierten Schaltkreisen nötige Instrumente handeln.

Für hochgenaue XY-Tische muss bei der Anordnung von Positionsmessgeräten die Abbe - Bedingung eingehalten werden. Dies ist bisher nur mit Planspiegel - Laserinterferometern und mit Kreuzgitter - Messsystemen möglich.

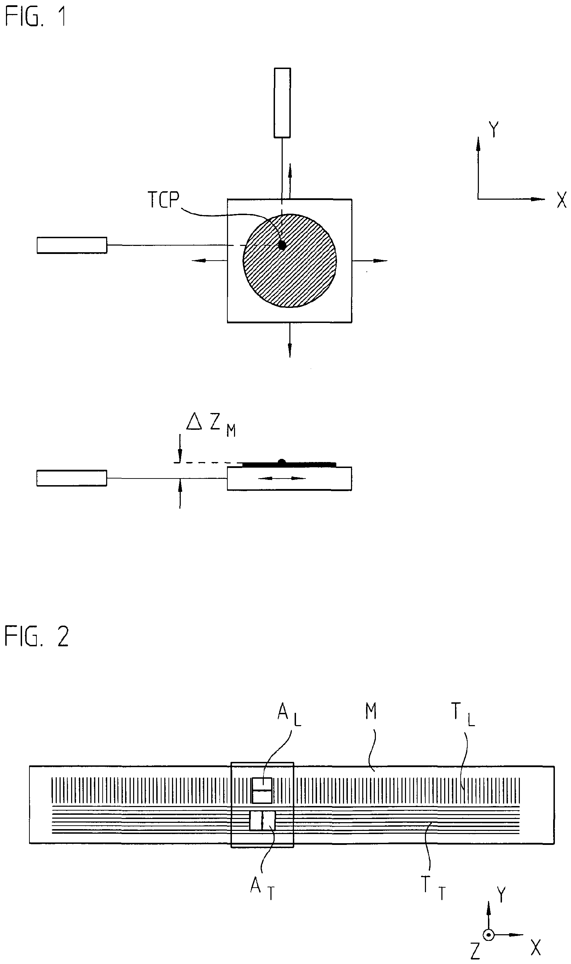

Mit Planspiegel - Laserinterferometern wird der Abstand zu den Seitenflächen eines beweglichen Tisches gemessen (siehe Figur 1). Die Messachsen des Laserinterferometers sind in der XY-Ebene jeweils zum Messpunkt des Werkzeuges (Tool Center Point TCP, z.B. Mikroskop, Elektronenstrahl, etc.) ausgerichtet. Eigentlich müssten die Messachsen des Laserinterferometers auch in z-Richtung (senkrecht zur Bearbeitungsebene) mit dem TCP fluchten. Jedoch wird dies meist nicht vorgesehen, um hochstehende Spiegelelemente zu vermeiden, die einen Zusammenstoß mit dem Werkzeug zur Folge haben könnten. Der Fehler, der bei Winkelfehlern der Führung des Tisches in Verbindung mit dem Abbe-Abstand $\Delta Z_M$ von ca. 20 mm entsteht, wir hierbei akzeptiert.

Der Nachteil dieser Anordnung ist zum einen der hohe Aufwand, der durch die Verwendung teurer Laserinterferometer verursacht wird. Darüber hinaus ist auch die Reproduzierbarkeit und Genauigkeit von Laserinterferometern in Luft sehr beschränkt. Durch die Brechungsindexschwankungen der Luftsäule ergeben sich selbst bei guten Laborbedingungen typische Abweichungen von 50 nm bei einer Luftsäule von 50 cm. Solch große Abweichungen sind für hochgenaue Anwendungen nicht tolerierbar.

Messanordnungen mit sogenannten Kreuzgitter - Encodern sind ebenfalls bekannt. Hier werden großflächige Maßstäbe mit einem Kreuzgitter von einem Abtastkopf abgetastet. Ein Beispiel für eine solche Messanordnung ist in der EP 1762828 A2 beschrieben. Die Herstellung von großen und hochgenauen Kreuzgittern ist jedoch sehr aufwändig.

Die DE 102006024579 A1 beschreibt daher eine Anordnung von Linearmaßstäben mit herkömmlichen Inkrementalteilungen zum Messen der Lage eines XY-Tisches.

Die US 6949733 B2 zeigt eine Vorrichtung, bei der ein Werkzeug mittels einer Gantry - Struktur über einem flächigen Werkstück bewegt wird. Zur Feststellung der Werkzeugposition dient eine Anordnung von mehreren sogenannten 1Dplus - Encodern, die im Wesentlichen die Positionsmessung in einer Messrichtung erlauben, aber auch kleine Bewegungen quer zu dieser Messrichtung erfassen können. In der vorgeschlagenen Anordnung, bei der ein Querarm oberhalb der Arbeitsebene bewegt wird, kann jedoch die Abbe - Bedingung nicht eingehalten werden, so dass bei Verkippungen durch Führungsfehler eine hochgenaue Positionserfassung nicht möglich ist.

Die US 4587622 zeigt ebenfalls eine Vorrichtung, bei der ein Werkzeug mittels einer Gantry - Struktur über einem flächigen Werkstück bewegt wird, auch hier kommen 1Dplus-Encoder am Querarm oberhalb der Bearbeitungsebene zum Einsatz.

Die US 2003/0053037 A1 zeigt einen XY-Tisch, dessen Position mit Interferometern gemessen wird. Solche Interfermoter sind jedoch anfällig für Schwankungen in den Umgebungsbedingungen.

Einzelheiten und vorteilhafte Ausgestaltungen von 1Dplus - Encodern sind in der DE 102005023984 A1 oder auch in der US 4758720 offenbart.

Aufgabe der Erfindung ist es, einen XY-Tisch mit einer Messanordnung von Encodern anzugeben, die der Abbe-Bedingung möglichst gut genügt und somit hohe Genauigkeiten bei der Positionsmessung und damit bei der Positionierung gewährleistet.

Diese Aufgabe wird gelöst durch eine Vorrichtung mit den Merkmalen des Anspruchs 1. Vorteilhafte Ausführungsformen ergeben sich aus den Merkmalen, die in den von Anspruch 1 abhängigen Ansprüchen aufgeführt sind.

Auf diese Weise lässt sich der von einem Werkzeug erfasste Punkt des Werkstücks oder allgemeiner des Objekts genau messen bzw. über geeignete Antriebe einstellen. Dieser besondere Punkt des Objekts wird auch als Tool Center Point oder kurz TCP bezeichnet.

Weitere Vorteile sowie Einzelheiten der vorliegenden Erfindung ergeben sich aus der nachfolgenden Beschreibung einer bevorzugten Ausführungsform anhand der Figuren. Dabei zeigen

Figur 1        einen XY-Tisch mit einer Anordnung von Laserinterferometern,
Figur 2        einen 1 Dplus-Encoder,
Figur 3        einen 1 Dplus-Encoder mit zusätzlichem Abtastkopf,
Figur 4        eine Messanordnung mit zwei 1Dplus-Encodern,
Figur 5        einen 1 Dplus-Encoder mit V-förmigen Teilungen,
Figur 6        ein erstes Ausführungsbeispiel,
Figur 7a, b, c   eine Erweiterung des ersten Ausführungsbeispiels,
Figur 8, 9     ein zweites Ausführungsbeispiel,
Figur 10       ein drittes Ausführungsbeispiel,

Figur 11          ein viertes Ausführungsbeispiel,
Figur 12          ein fünftes Ausführungsbeispiel.

Für jede hochgenaue Positionsbestimmung ist, wie oben erwähnt, die Einhaltung der Abbe-Bedingung wichtig, um Ungenauigkeiten durch Kippbewegungen zu minimieren. Bei Encodern bedeutet diese Bedingung, dass der Objektpunkt, dessen Position bestimmt werden soll, und die effektiven Messorte der Encoder in Verlängerung entlang deren Messrichtungen liegen müssen. Der effektive Messort eines Encoders wird dabei durch seinen neutralen Drehpunkt ($X_{NP}$, $Y_{NP}$, $Z_{NP}$) vorgegeben und definiert sich dadurch, dass eine Kippung des Abtastkopfes oder des Maßstabs um den neutralen Drehpunkt keine lineare Änderung des angezeigten Positionswertes ergibt. Der neutrale Drehpunkt eines Encoders liegt meist mittig in seinem Abtastfeld entweder in Höhe des Maßstabs oder in Höhe der Abtastteilung im Abtastkopf.

Hochgenaue XY-Tische erfordern aber nicht nur die Einhaltung der Abbe-Bedingung und damit die Minimierung des Einflusses von Kippbewegungen der Tischführungen. Es müssen darüber hinaus auch die linearen Querbewegungen der Führungen, insbesondere die Geradheitsabweichungen in der Bewegungsebene (XY) des Tisches erfasst und korrigiert werden.

In vielen Applikationen muss nur in der Tischebene (XY) eine hochgenaue Positionsbestimmung erfolgen. Neben den entsprechenden Positionswerten X und Y ist aber häufig auch die Rotation Rz des Tisches um die Achse Z senkrecht zur Tischebene wichtig, wenn das verwendete Werkzeug eine nennenswerte Ausdehnung in der XY-Ebene aufweist. Dies ist z.B. bei einem Mikroskop mit einem nicht zu vernachlässigendem Beobachtungsfeld der Fall. Die Freiheitsgrade X, Y und Rz werden im Nachfolgenden als in-plane Freiheitsgrade bezeichnet. Demgegenüber brauchen die restlichen, sogenannten out-of-plane Freiheitsgrade Rx, Ry und Z meist gar nicht oder nicht so genau bestimmt werden. Dies trifft z.B. für ein Mikroskop mit einer großen Fokustiefe zu. Wichtig ist aber, dass genau derjenige Objektpunkt TCP durch die Encoder gemessen wird, der auch vom Werkzeug erfasst wird. Sein Ort liegt bei ($X_{TCP}$, $Y_{TCP}$, $Z_{TCP}$).

Erfindungsgemäß soll die Einhaltung der Abbe-Bedingung und die Erfassung von Querbewegungen des Tisches durch die Verwendung sogenannter 1Dplus Encoder erfolgen. 1Dplus Encoder (siehe. Figur 2) besitzen neben einer Längsspur $T_L$ auch eine Querspur $T_T$. Der Abtastkopf $A_L$, der die Längsspur $T_L$ abtastet, misst entlang der langen Ausdehnung X des Maßstabs. Der Abtastkopf $A_T$ dagegen tastet die Querspur $T_T$ ab und misst entlang der kurzen Ausdehnung Y des Maßstabs M.

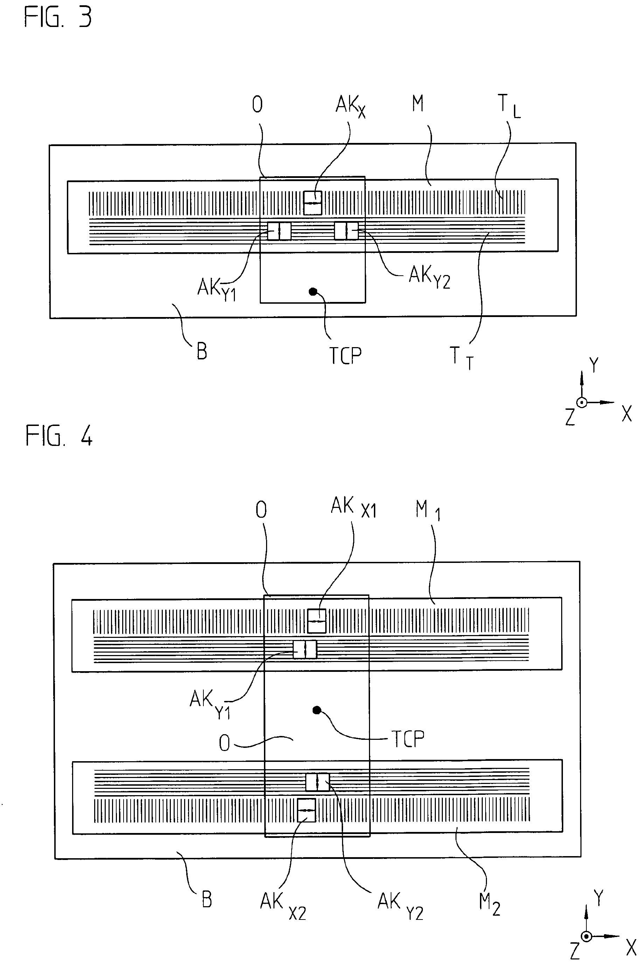

Mit Hilfe eines dritten Abtastkopfs lässt sich auch der in-plane Freiheitsgrad Rz (Rotation um die z-Achse) messen. Dafür gibt es zwei Grundkonfigurationen. Die erste ist in Figur 3 dargestellt und weist nur einen auf einem Referenzteil B montierten Maßstab M auf, der von drei, auf einem Objekt O befestigten Abtastköpfen $AK_{Y1}$, $AK_{Y2}$ und $AK_X$ abgetastet wird. Jeder der Abtastköpfe tastet den Maßstab M jeweils an seinem effektiven Abtastort ($X_{NP,Y1}$,$Y_{NP,Y1}$,$Z_{NP,Y1}$), ($X_{NP,Y2}$,$Y_{NP,Y2}$,$Z_{NP,Y2}$) bzw. ($X_{NP,X}$,$Y_{NP,X}$,$Z_{NP,X}$) ab. Die drei Abtastköpfe liefern die Positionswerte $\xi_{Y1}$, $\xi_{Y2}$ bzw. $\xi_X$.

Es wird im Folgenden angenommen, dass der zu bestimmende Objektort TCP in Z-Richtung mit den Z-Lagen der effektiven Abtastorte aller Abtastköpfe übereinstimmt:

$$Z_{NP,Y1} = Z_{NP,Y2} = Z_{NP,X} = Z_{TCP}$$

(Gl. 1)

Die beiden Abtastköpfe $AK_{Y1}$ und $AK_{Y2}$ erfassen nicht nur die Y-Verschiebung des Objekts O relativ zum Maßstab M bzw. zum Referenzteil B sondern auch die Drehung $Rz_{O-B}$ um die z-Achse. Für kleine Rotationen $Rz_{O-B}$ gilt näherungsweise:

$$Rz_{O-B} = (\xi_{Y2} - \xi_{Y1})/(X_{NP,Y2} - X_{NP,Y1}).$$

(Gl. 2)

Zur Bestimmung der Lage ($X_{O-B}$, $Y_{O-B}$) des Objekts O relativ zum Referenzteil B an der Stelle des TCP muss die von der Rotation $Rz_{O-B}$ bewirkte Verschiebung zwischen den effektiven Abtastorten ($X_{NP,X}$, $Y_{NP,X}$), ($X_{NP,Y1}$, $Y_{NP,Y1}$), ($X_{NP,Y2}$, $Y_{NP,Y2}$) der Abtastköpfe $AK_X$, $AK_{Y1}$, $AK_{Y2}$ und dem TCP berücksichtigt werden:

$$X_{O-B} = \xi_X + Rz_{O-B} \cdot (Y_{NP,X} - Y_{TCP})$$

$$Y_{O-B} = \xi_{Y1} - Rz_{O-B} \cdot (X_{NP,Y1} - X_{TCP})$$

(Gl. 3)

Diese Berechnung gilt für jede beliebige Lage des TCP relativ zu den Lagen der Abtastköpfe. Jedoch nimmt mit zunehmendem Abstand die Genauigkeit der Bestimmung der Lage ($X_{O-B}$, $Y_{O-B}$) ab. Dieser Abstand sollte deshalb möglichst klein gewählt werden.

Eine weitere Möglichkeit zur Bestimmung der Objektlage ($X_{O-B}$, $Y_{O-B}$) ist in Figur 4 dargestellt. Hier werden zwei auf dem Referenzteil B montierte Maßstäbe $M_1$ und $M_2$ von insgesamt vier, auf dem Objekt O befestigten Abtastköpfen $AK_{X1}$, $AK_{X2}$, $AK_{Y1}$, $AK_{Y2}$ abgetastet. In diesem Fall wird die Rotation $Rz_{O-B}$ durch die Positionswerte $\xi_{X1}$ und $\xi_{X2}$ der in X-Richtung messenden Abtastköpfe $AK_{X1}$ und $AK_{X2}$ gemessen:

$$Rz_{O-B} = -(\xi_{X2} - \xi_{X1})/(Y_{NP,X2} - Y_{NP,X1})$$

(Gl. 4)

Die Lage des Objekts O am Ort des TCP lässt sich in analoger Weise mit nur einem weiteren Abtastkopf, z.B. $AK_{Y1}$ bestimmen:

$$X_{O-B} = \xi_{X1} + Rz_{O-B} \cdot (Y_{NP,X1} - Y_{TCP})$$

$$Y_{O-B} = \xi_{Y1} - Rz_{O-B} \cdot (X_{NP,Y1} - X_{TCP})$$

(Gl. 5)

Bei einem weiteren Abtastkopf $AK_{Y2}$ ist es aber vorteilhaft, auch die entsprechende, redundante Positionsinformation $\xi_{Y2}$ einzuschließen, so dass sich statt Gl. 5 ergibt:

$$X_{O-B} = \xi_{X1} + Rz_{O-B} \cdot (Y_{NP,X1} - Y_{TCP})$$

$$Y_{O-B} = \eta \cdot [\xi_{Y1} - Rz_{O-B} \cdot (X_{NP,Y1} - X_{TCP})] + (1-\eta) \cdot [\xi_{Y2} - Rz_{O-B} \cdot (X_{NP,Y2} - X_{TCP})]$$

(Gl. 6)

Der Gewichtungsfaktor $\eta$ kann grundsätzlich beliebig gewählt werden. Es ist jedoch vorteilhaft, diesen Gewichtungsfaktor $\eta$ so setzen, dass auch die thermische Ausdehnung von Komponenten zumindest bei einer gleichmäßigen Erwärmung des Objekts O und des Referenzteils B kompensiert wird. Die thermische Ausdehnung kann durch die redundante Messung der Y-Lage des Objekts O durch die Abtastköpfe $AK_{Y1}$ und $AK_{Y2}$ bestimmt werden. Anteilig zu den Abständen der Abtastköpfe $AK_{Y1}$ und $AK_{Y2}$ vom TCP kann daher die thermisch korrigierte Y-Position $Y_{O-B}$ des Objekts O am Ort des TCP berechnet werden. Je näher der TCP zu einem der Abtastköpfe $AK_{Y1}$ oder $AK_{Y2}$ liegt, desto stärker muss dessen Messwert gewichtet werden.

Damit ergibt sich als optimaler Gewichtungsfaktor

$$\eta = \frac{Y_{TCP} - Y_{NP,Y2}}{Y_{NP,Y1} - Y_{NP,Y2}}$$

(Gl. 7)

Auch eine Korrektur der thermischen Ausdehnung in X-Richtung ist möglich. Dazu wird zunächst die Längenänderung in Y-Richtung zwischen den Abtastköpfen $AK_{Y1}$ und $AK_{Y2}$ in eine Temperaturänderung $\Delta T$ umgerechnet:

$$\Delta T = \frac{[\xi_{Y1} - Rz_{O-B} \cdot (X_{NP,Y1} - X_{TCP})] - [\xi_{Y2} - Rz_{O-B} \cdot (X_{NP,Y2} - X_{TCP})]}{\Delta CTE_{O-B} \cdot (Y_{NP,Y1} - Y_{NP,Y2})}$$

(Gl. 8)

Der Parameter $\Delta CTE_{O-B}$ bezeichnet die Differenz des thermischen Ausdehnungskoeffizienten $CTE_O$ des Objekts und des thermischen Ausdehnungskoeffizienten $CTE_B$ des Referenzteils B. Mit Hilfe der Temperaturänderung $\Delta T$ und der thermischen Ausdehnungskoeffizienten der beteiligten Bauteile können dann auch die thermischen Verschiebungen in X-Richtung bestimmt werden, wobei die Fixierpunkte der Bauteile untereinander natürlich berücksichtigt werden müssen. Auf eine detaillierte Beschreibung wird hier verzichtet, da es für den Fachmann einfach ist, mit der bekannten Temperaturänderung $\Delta T$ diese Berechnung durchzuführen. Die thermische Korrektur in Längsrichtung der Maßstäbe wird auch in den unten beschriebenen Ausführungsformen nicht weiter ausgeführt, kann aber selbstverständlich verwendet werden.

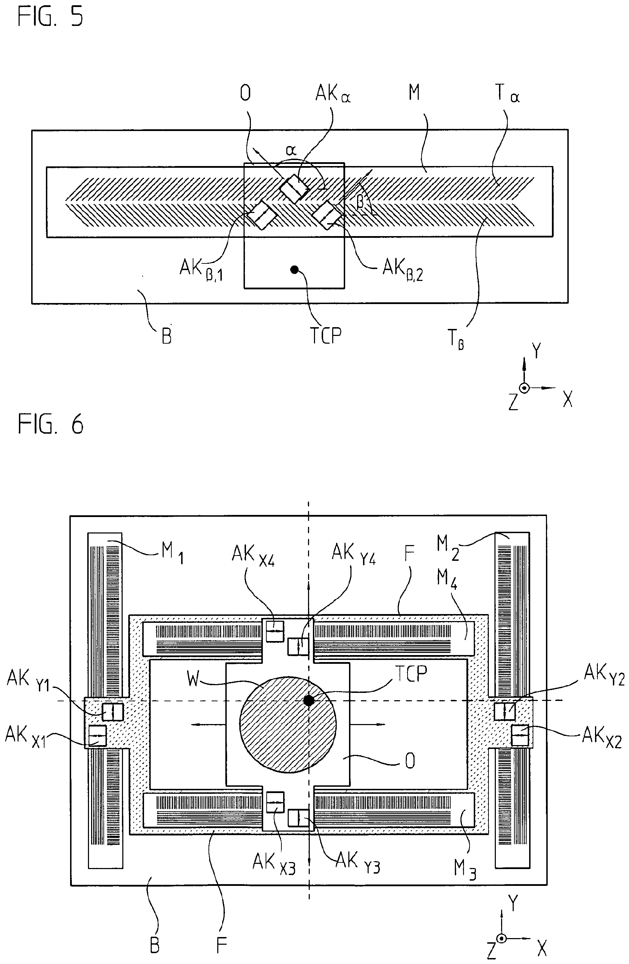

Statt einer Längsteilung $T_L$ und einer Querteilung $T_T$ können ebenso gut V-förmige Teilungen $T_\alpha$ und $T_\beta$ gemäß Figur 5 verwendet werden, die durch entsprechend geneigte Abtastköpfe $AK_\alpha$, $AK_{\beta,1}$ und $AK_{\beta,2}$ abgetastet werden. Beispielsweise kann man $\alpha=135°$ und $\beta=45°$ wählen. Solche Teilungen bieten den Vorteil, dass bei einer Bewegung in der Hauptbewegungsrichtung, d.h. in der Längsrichtung des Maßstabs, stets Positionsänderungen bei der Abtastung beider Spuren auftreten. Eine Signalkompensation, wie sie z.B. in der oben genannten DE 102005023984 A1 in Absatz [0029] beschrieben wird, ist damit einfach und mit hoher Genauigkeit möglich. Bei einer Querteilung $T_T$ gemäß Figur 2 ist die Querbewegung (hier in Y-Richtung) meist sehr gering, so dass kaum Positionsänderungen auftreten und die Signalkompensation nicht neue Kompensationsparameter erfassen kann und somit Interpolationsfehler unvermeidbar sind.

Aus den Messwerten $\xi_\alpha$, $\xi_{\beta,1}$ und $\xi_{\beta,2}$ können analog zu Gl. 2 und Gl. 3 Positionswerte $X_{O-B}$, $Y_{O-B}$ und $Rz_{O-B}$, bestimmt werden. Der Fachmann kann die entsprechenden Transformationsgleichungen leicht aufstellen. Solche V-förmige Teilungen liefern damit äquivalente Positionsinformationen.

In den unten beschriebenen Ausführungsbeispielen sind der Einfachheit halber alle Maßstäbe mit Längs- und Querteilungen ($T_L$, $T_T$) gezeigt. In der Praxis ist es aber vorteilhaft V-förmige Teilungen zu verwenden. Wie in der DE 102005023984 A1 in Absatz [0023] beschrieben, ist es dann auch möglich, für beide Teilungsspuren Referenzmarken anzuordnen und zu detektieren, selbst wenn keine Querbewegung auftritt.

1. Ausführungsbeispiel:

In Figur 6 ist eine erste Ausführungsform dargestellt. Ein Zwischenteil F ist in Y-Richtung verschiebbar gegenüber einem ortsfesten Referenzteil B gelagert. Weiterhin ist relativ zum Zwischenteil F das Objekt O (hier ein Messtisch) mit dem zu messenden bzw. zu bearbeitenden Teil W, z.B. ein Wafer, in X-Richtung verschiebbar gelagert. Durch eine kombinierte Verschiebung lässt sich das Objekt 0 in X- und Y-Richtung relativ zum ortsfesten Referenzteil B verschieben. Ein solcher Aufbau wird deshalb als sequentielle Anordnung von Lineartischen bezeichnet. Führungselemente sind in Figur 6 nicht dargestellt.

Die Abtastköpfe $AK_{X1}$,... $AK_{X4}$ erfassen die X-Bewegung relativ zu den zugehörigen Maßstäben $M_1$,...$M_4$, die Abtastköpfe $AK_{Y1}$,... $AK_{Y4}$ die entsprechenden Y-Bewegungen. Die beiden Maßstäbe $M_1$ und $M_2$ sind am ortsfesten Referenzteil B befestigt. Die Abtastköpfe $AK_{X1}$, $AK_{Y1}$, $AK_{X2}$ und $AK_{Y2}$ und die Maßstäbe $M_3$ und $M_4$ sind am bewegten Zwischenteil F montiert. Auf dem Objekt O befinden sich schließlich die Abtastköpfe $AK_{X3}$, $AK_{Y3}$, $AK_{X4}$ und $AK_{Y4}$. Durch die Anordnung von Abtastköpfen und Maßstäben werden die Bewegungen des Objekts O relativ zum Zwischenteil F und des Zwischenteils F relativ zum ortsfesten Referenzteil B jeweils in den Freiheitsgraden X, Y und Rz gemessen. Die Z-Lagen aller Encoder stimmen mit der Z-Lage des TCP überein:

$$Z_{NP,X1} = Z_{NP,Y1} = Z_{NP,X2} = Z_{NP,Y2} = Z_{NP,X3} = Z_{NP,Y3} = Z_{NP,X4} = Z_{NP,Y4} = Z_{TCP}$$

(Gl. 9)

Für die Bestimmung der relativen Lage $X_{F-B}$, $Y_{F-B}$, $Rz_{F-B}$ des Zwischenteils F relativ zum ortsfesten Referenzteil B am Ort des TCP gilt:

$$Rz_{F-B} = (\xi_{Y2} - \xi_{Y1})/(X_{NP,Y2} - X_{NP,Y1})$$

$$X_{F-B} = \eta_{F-B} \cdot [\xi_{X1} - Rz_{F-B} \cdot (Y_{TCP} - Y_{NP,X1})] + (1 - \eta_{F-B}) \cdot [\xi_{X2} - Rz_{F-B} \cdot (Y_{TCP} - Y_{NP,X2})]$$

$$Y_{F-B} = \xi_{Y1} + Rz_{F-B} \cdot (X_{TCP} - X_{NP,Y1})$$

$$\eta_{F-B} = \frac{X_{NP,X2} - X_{TCP}}{X_{NP,X2} - X_{NP,X1}}$$

(Gl. 10)

Analog gilt für die Bestimmung der Lage $X_{O-F}$, $Y_{O-F}$, $Rz_{O-F}$ des Objektes O relativ zum Zwischenteil F:

$$Rz_{O-F} = -(\xi_{X4} - \xi_{X3})/(Y_{NP,X4} - Y_{NP,X3})$$

$$X_{O-F} = \xi_{X3} + Rz_{O-F} \cdot (Y_{NP,X3} - Y_{TCP})$$

$$Y_{O-F} = \eta_{O-F} \cdot [\xi_{Y3} - Rz_{O-F} \cdot (X_{NP,Y3} - X_{TCP})] + (1 - \eta_{O-F}) \cdot [\xi_{Y4} - Rz_{O-F} \cdot (X_{NP,Y4} - X_{TCP})]$$

$$\eta_{O-F} = \frac{Y_{NP,Y4} - Y_{TCP}}{Y_{NP,Y4} - Y_{NP,Y3}}$$

(Gl. 11)

Natürlich ist es möglich die Gewichtungsfaktoren $\eta_{F-B}$ und/oder $\eta_{O-F}$ auch auf die Werte 1 zu setzen. In diesen Fällen benötigt man die Abtastköpfe $AK_{X2}$ bzw. $AK_{Y4}$ nicht mehr, wobei die oben beschriebene, thermische Korrekturmöglichkeit entfällt.

Die Bestimmung der Lage $X_{O-B}$, $Y_{O-B}$ und des Drehwinkels $Rz_{O-B}$ des Objekts O relativ zum feststehenden Referenzteil B am Ort des TCP erfolgt durch eine Addition der Relativlagen des Objekts O zum Zwischenteil F und des Zwischenteils F zum feststehenden Referenzteil B:

$$X_{O-B} = X_{O-F} + X_{F-B}$$

$$Y_{O-B} = Y_{O-F} + Y_{F-B}$$

$$Rz_{O-B} = Rz_{O-F} + Rz_{F-B}$$

(Gl. 12)

Durch die Bestimmung sowohl der X- als auch der Y-Lagen beider bewegten Teile F und O werden auch Führungsfehler wie z.B. Geradheitsabweichungen erfasst und durch eine nicht dargestellte Regelung und entsprechende Antriebe korrigiert.

Für die Genauigkeit der erfindungsgemäßen Anordnung ist es wichtig, dass alle zur Lagebestimmung relevanten Teile B, F und O stabil bleiben. Dies wird zum einen durch die Wahl geeigneter Materialien bestimmt. So ist es oft vorteilhaft, Materialien mit geringer Ausdehnung, wie z.B. Zerodur oder Invar, oder auch Materialien mit guter Wärmeleitung, wie z.B. Aluminium, zu verwenden. Zum anderen dürfen aber auch keine Kräfte wirken, die diese Teile B, F und O verbiegen oder in ihrer Länge beeinflussen.

Bei hochgenauen XY-Tischen, die bisher oftmals mit Laserinterferometern ausgerüstet sind, werden teilweise zwei getrennte, ortsfeste Trägerstrukuren verwendet. Eine erste Trägerstruktur soll alle Kräfte ableiten, die zur Halterung und Bewegung der Bauteile eingeleitet werden müssen. Diese Trägerstruktur wird als Kräfterahmen bezeichnet. Eine zweite, davon entkoppelte Trägerstruktur dient zur Aufnahme aller Bauteile, die für die Messung der Relativpositionen erforderlich sind. Diese Trägerstruktur heißt Messrahmen. Durch die Entkoppelung des Messrahmens vom Kräferahmen wird verhindert, dass Verformungen des Messrahmens und damit Messfehler entstehen. Die Entkoppelung kann durch eine Verbindungsmechanik mit flexiblen Elementen oder durch eine Schwingungsisolation erfolgen. Bei bisherigen Maschinen sind beide Rahmen ortsfest und bewegen sich nicht.

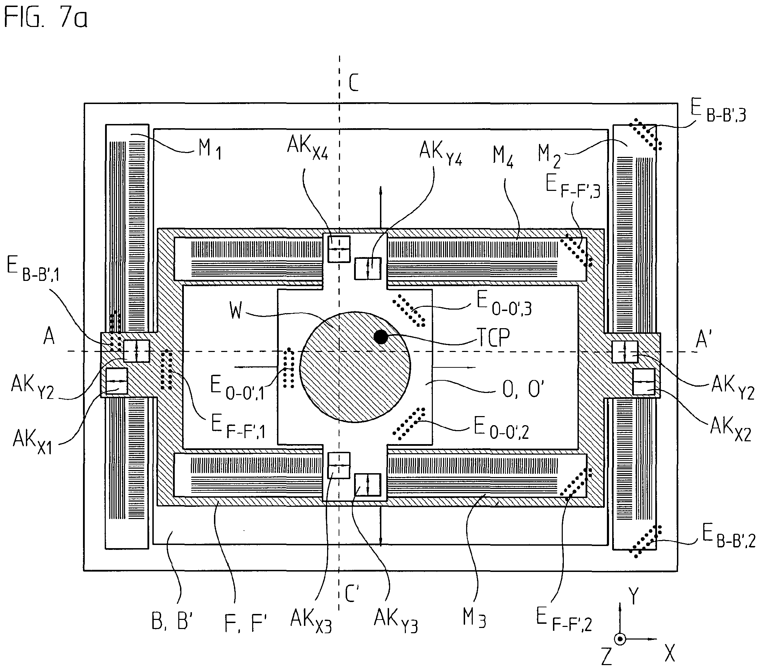

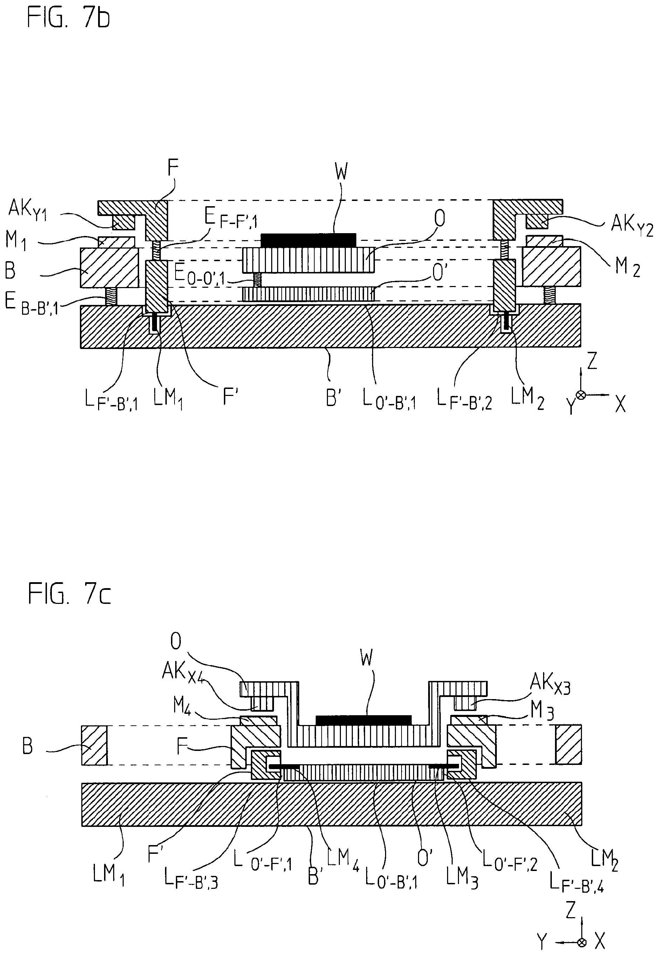

Die Figuren 7a (Draufsicht), 7b (Schnitt AA') und 7c (Schnitt CC') zeigen eine Erweiterung dieses Konstruktionsprinzips. Jedes der Bauteile B, F und O tragen Komponenten der Encoder und werden deshalb als Messrahmenelemente bezeichnet. Davon jeweils durch Entkoppelungselemente $E_{B'-B,n}$, $E_{F'-F,n}$ und $E_{O'-O,n}$ (n=1,2,3) getrennt gibt es die Bauteile B', F' und O'. Das Bauteil B' ist ortsfest, das Bauteil F' wird im Wesentlichen zusammen mit dem Bauteil F entlang der Y-Richtung bewegt und das Bauteil O' wird im Wesentlichen zusammen mit dem Bauteil O entlang X und Y bewegt. An den Bauteilen B', F' und O' sind die Kraft erzeugenden Elemente befestigt, wie z.B. die Führungselemente $L_{O'-F',n}$, $L_{F'-B',n}$ und $L_{O'-B',n}$ (n=1,2,...), die hier als Luftlager ausgebildet sind, und auch die Linearmotoren $LM_n$ (n=1,2,3,4). Die Entkoppelungselemente $E_{B'-B,n}$, $E_{F'-F,n}$ und $E_{O'-O,n}$ sind vorteilhafterweise als Festkörpergelenke so ausgeführt, dass grundsätzlich alle sechs Freiheitsgrade der verbundenen Bauteile zueinander gesperrt sind, aber eine Überbestimmung vermieden wird. Eine solche Verbindung wird oftmals auch als eine kinematische Verbindung bezeichnet. Durch das Fehlen von Überbestimmungen werden Verbiegungen der Messrahmenelemente vermieden. In Figur 7a sind beispielsweise die Entkoppelungselemente $E_{B'-B,n}$, $E_{F'-F,n}$ und $E_{O'-O,n}$ in radialer Richtung flexibel, während sie in tangentialer Richtung starr sind.

2. Ausführungsbeispiel

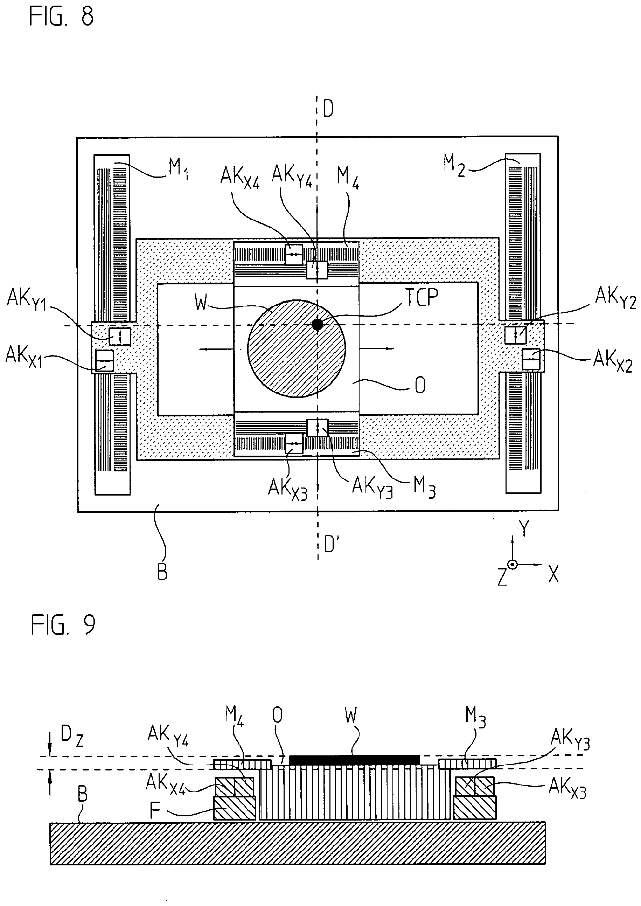

Bei der zweiten Ausführungsform gemäß Figur 8 und Figur 9 sind auf dem Zwischenteil F statt den Maßstäben die Abtastköpfe $AK_{X3}$, $AK_{Y3}$, $AK_{X4}$ und $AK_{Y4}$ befestigt. Die Maßstäbe $M_3$ und $M_4$ sind hier mit dem Objekt O fest verbunden. Der sonstige Aufbau gleicht der ersten Ausführungsform und wird hier nicht noch einmal beschrieben.

Durch die Befestigung der Maßstäbe $M_3$ und $M_4$ auf dem Objekt O kann das Zwischenteil F einfacher ausgeführt sein. Es muss nicht mehr einen auf Biegung äußerst empfindlichen Maßstab tragen. Die Abtastköpfe sind im Vergleich dazu deutlich robuster. Dennoch muss das Zwischenteil F die Abtastköpfe positionsstabil haltern. Da das Objekt O das zu messende Teil W trägt, muss es in jedem Fall steif und positionsstabil aufgebaut sein. Der Mehraufwand durch die Befestigung der Maßstäbe $M_3$ und $M_4$ ist also minimal.

Die effektiven Messpunkte der Abtastköpfe $AK_{Y3}$ und $AK_{Y4}$ werden hier vorteilhaft in X-Richtung fluchtend mit dem TCP angeordnet:

$$X_{NP,Y3} = X_{NP,Y4} = X_{TCP}$$

Dadurch vereinfachen sich die Berechnungsformeln.

In vielen Anwendungen dürfen keine Teile in Z-Richtung über das Messobjekt W hinausragen, um eine Kollision mit dem Werkzeug auch in Fehlerfällen zu verhindern. Solche Fehlerfälle können z.B. auftreten, wenn bei hoher Tischgeschwindigkeit ein Stromausfall auftritt. Um solche Kollisionen zu verhindern, werden in dieser Ausführungsform die Maßstab $M_3$ und $M_4$ mit der Teilung zum Referenzteil B hin ausgerichtet (siehe Figur 9) und ihre Oberseite mit dem Messobjekt W nivelliert, d.h. auf gleiche Z-Höhe gebracht. Vorteilhafterweise werden hier Encoder eingesetzt, deren effektiver Messort $Z_{NP}$ auf der Teilungsseite des Maßstabs liegt oder auch im Substratbereich des Maßstabs. Auf diese Weise lässt sich zwar die Abbe-Bedingung nicht mehr vollständig erfüllen. Der resultierende Abbe-Abstand $D_Z$ bleibt aber sehr gering. Werte von kleiner 5 mm sind durchaus erreichbar.

In dieser Ausführungsform sind die Maßstäbe $M_1$ und $M_2$, bzw. $M_3$ und $M_4$ zueinander spiegelsymmetrisch angeordnet. Dasselbe gilt auch für die zugehörigen Abtastköpfe. Diese Symmetrie erlaubt eine symmetrische Gestaltung der Bauteile B, F und O. Sie bietet grundsätzlich eine höhere Genauigkeit, da viele ortsabhängige Fehleranteile, die dieselbe Spiegelsymmetrie aufweisen, sehr klein gehalten werden können.

3. Ausführungsbeispiel

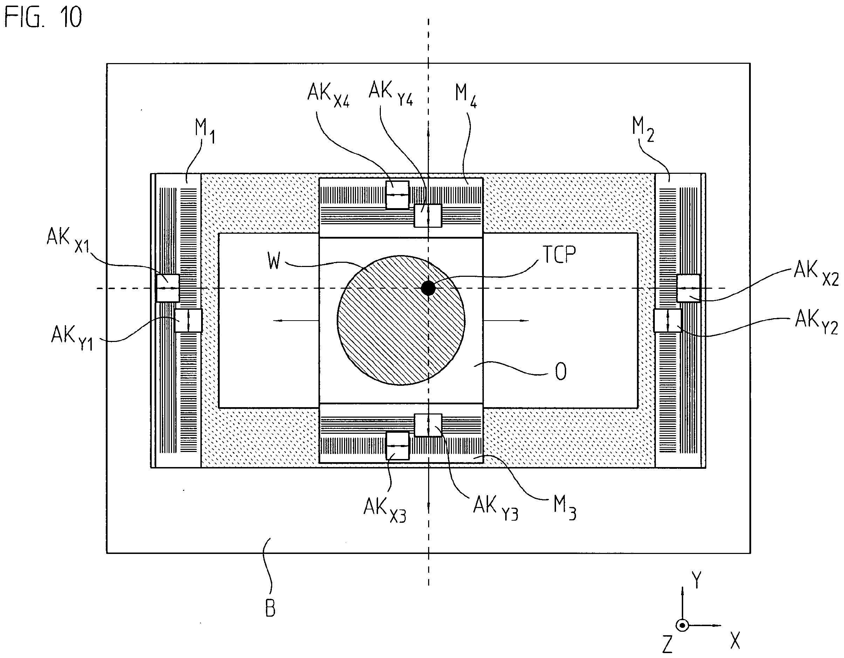

Bei der dritten Ausführungsform gemäß Figur 10 befinden sich die Maßstäbe $M_1$ und $M_2$ auf dem bewegten Zwischenteil F und die zugehörigen Abtastköpfe $AK_{X1}$, $AK_{Y1}$, $AK_{X2}$ und $AK_{Y2}$ sind ortsfest mit dem Referenzteil B verbunden. Wie in der zweiten Ausführungsform sind die Maßstäbe $M_3$ und $M_4$ am Objekt O angebracht und die zugehörigen Abtastköpfe $AK_{X3}$, $AK_{Y3}$, $AK_{X4}$ und $AK_{Y4}$ am Zwischenteil F befestigt.

Die Abtastköpfe $AK_{X1}$, $AK_{X2}$, $AK_{Y3}$ und $AK_{Y4}$ lassen sich in dieser Ausführungsform so anordnen, dass ihr effektiver Messpunkt stets zum TCP entlang ihrer Messrichtung ausgerichtet ist. Für die zugehörigen Positionswerte entfällt damit die Korrektur mit dem Winkel Rz, was die Auswertung der Positionssignale vereinfacht.

4. Ausführungsbeispiel

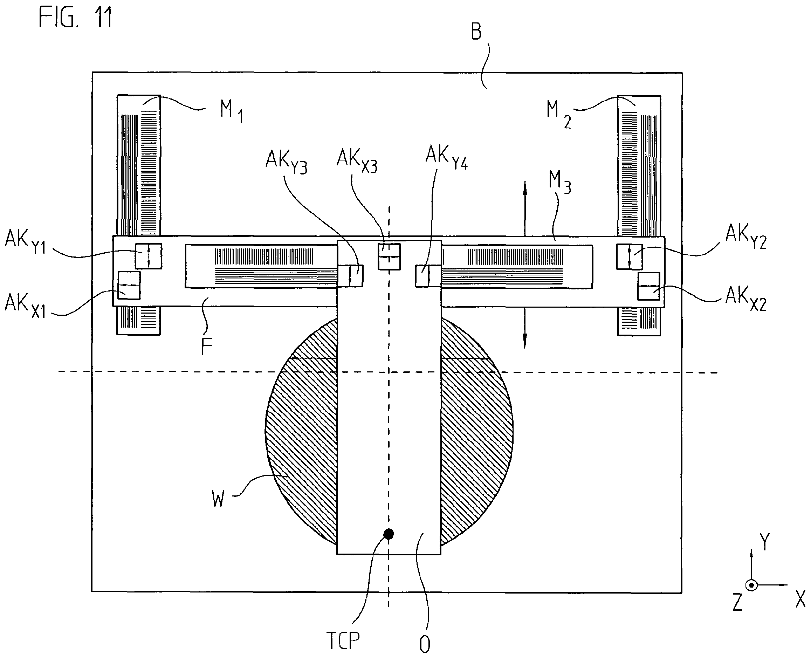

Bei der vierten Ausführungsform gemäß Figur 11 wird nicht mehr das zu messende Teil W relativ zum feststehenden TCP bewegt. Vielmehr befindet sich das zu messende Teil auf dem ortsfesten Referenzteil B und das Werkzeug bzw. der TCP wird mit dem Objekt O mitbewegt. Die grundsätzlichen Berechnungen erfolgen in gleicher Weise wie oben beschrieben, die Position ($X_{TCP}$, $Y_{TCP}$) des TCP ist allerdings nicht mehr konstant, sondern ändert sich mit der Tischposition. Auf einen vierten Maßstab wird in diesem Ausführungsbeispiel verzichtet. Stattdessen wird der Maßstab $M_3$ durch drei Abtastköpfe $AK_{X3}$, $AK_{Y3}$ und $AK_{Y4}$ abgetastet. Die beiden auf der Querspur $T_T$ abtastenden Abtastköpfe $AK_{Y3}$ und $AK_{Y4}$ erfassen nicht nur die Y-Lage des Objekts O relativ zum Zwischenteil F sondern auch die zugehörige Rotation $Rz_{O-F}$. Wie bei den obigen Ausführungsbeispielen sind alle effektiven Messpunkte der Abtastköpfe und der TCP in Z-Richtung auf gleicher Höhe:

$$Z_{NP,X1} = Z_{NP,Y1} = Z_{NP,X2} = Z_{NP,Y2} = Z_{NP,X3} = Z_{NP,Y3} = Z_{NP,Y4} = Z_{TCP}$$

Das Zwischenteil F muss deshalb zumindest teilweise neben dem zu bearbeitenden Teil W angeordnet sein. Nur auf diese Weise kann die Abbe-Bedingung eingehalten werden. Die übliche Anordnung einer Gantry-Maschine, bei der das Messgerät und der Antrieb für die Y-Richtung über dem Messobjekt hinwegbewegt wird, genügt dieser Bedingung nicht.

5. Ausführungsbeispiel

Das fünfte Ausführungsbeispiel weist wie das zweite Ausführungsbeispiel ein Zwischenteil F auf, das alle Abtastköpfe $AK_{X1}$, $AK_{Y1}$, ... $AKX_{4b}$, $AK_{Yb}$ trägt. Die Maßstäbe M1 und M2 sind wiederum am feststehenden Referenzteil B befestigt, während die Maßstäbe M3 und M4 am Objekt 0 angebracht sind. Die Abtastung des Maßstabs M3 erfolgt hier redundant mit vier Abtastköpfen $AK_{X3a}$, $AK_{Y3a}$, $AK_{X3b}$, $AK_{Y3b}$ wobei die Paare von Abtastköpfen $AK_{X3a}$/$AK_{X3b}$ bzw. $AK_{Y3a}$/$AK_{Y3b}$ jeweils dieselbe Spur des Maßstabs M3 abtasten. Die beiden Abtastköpfe eines Paares sind in X-Richtung jeweils zur Mitte des Zwischenteils F symmetrisch versetzt. In den mittleren X-Lagen des Objekts O relativ zum Zwischenteil F können damit beide Abtastköpfe eines Paares den Maßstab M3 abtasten, in den äußeren Lagen kann dies jeweils nurmehr mit einem der beiden Abtastköpfe eines Paares erfolgen. Bei einer begrenzten Länge des Maßstabs M3 erweitert sich damit der Messbereich in X-Richtung auf einen Wert, der ungefähr um den Abstand der beiden Paare von Abtastköpfen $AK_{X3a}$/$AK_{X3b}$ bzw. $AK_{Y3a}$/$AK_{Y3b}$ größer ist als die Länge des Maßstabes M3.

Auf der gegenüberliegenden Seite des Objekts wird der Maßstab M4 in analoger Weise durch die Abtastkopfpaare ($AK_{X4a}$, $AK_{X4b}$) und ($AK_{Y4a}$, $AK_{Y4b}$) abgetastet. Die Bestimmung der Objektlage $X_{O-B}$, $Y_{O-B}$, $Rz_{O-B}$ erfolgt wieder analog zu den Gleichungen 10 - 12, wobei jeweils der Abtastkopf eines redundanten Abtastkopfpaares ausgewählt wird, der dem zugehörigen Maßstab gegenübersteht und diesen abtasten kann. Wenn in den mittleren X-Lagen des Objekts O beide Abtastköpfe den zugehörigen Maßstab abtasten können, können die Objektlage $X_{O-B}$, $Y_{O-B}$, $Rz_{O-B}$ doppelt bestimmt und die Ergebnisse gemittelt werden.

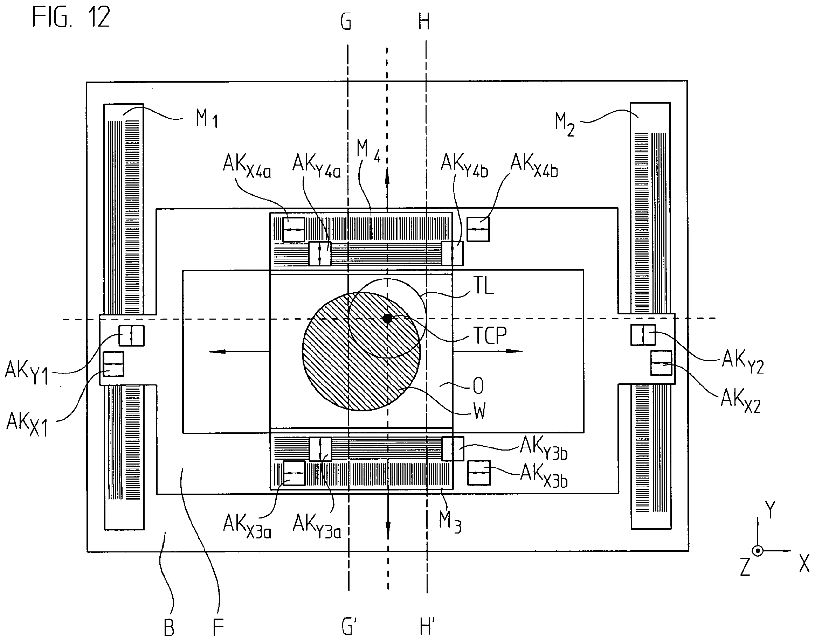

Die Z-Lagen der effektiven Messorte aller Encoder stimmen bei diesem Ausführungsbeispiel wiederum mit der Z-Lage des TCP überein. Dies wird dadurch erreicht, dass die Z-Lagen aller Abtastköpfe über das Messobjekt W hinausragen und die Maßstäbe mit dem TCP nivelliert werden. Als besonderer Vorteil dieses Ausführungsbeispiels kann eine Kollision der Abtastköpfe mit dem Werkzeug bei jeder möglichen Lage des Objekts O ausgeschlossen werden. Dazu müssen gemäß Fig. 12 die Abtastköpfe, die die Maßstäbe M3 und M4 abtasten, entweder links der Linie GG' oder rechts der Linie HH' liegen, wenn die Linien GG' bzw. HH' die Ausdehnung des Werkzeugs in X-Richtung markieren.

Weitere Hinweise:

Allen gezeigten Ausführungsbeispielen ist gemeinsam, dass die 1Dplus-Encoder M1, M2, M3, M4 und insbesondere deren Maßstäbe konstruktiv so angeordnet sind, dass deren Projektion in eine durch die erste und zweite Richtung X, Y aufgespannte Ebene, die den Tool Center Point TCP enthält, im gesamten Verfahrbereich des XY-Tisches außerhalb des zu bearbeitenden Teils W liegt. Erst durch diese Maßnahme wird die möglichst gute Einhaltung der Abbe-Bedingung ermöglicht, denn so können alle Maßstäbe bzw. effektive Messorte der 1DPlus-Encoder auch in Z-Richtung mit dem Tool Center Point fluchten. Gantry-Strukturen, bei denen ein Encoder am Querbalken angeordnet ist, dessen Projektion in die Arbeitsebene und damit auf das Teil W fällt, können diese Bedingung nicht erfüllen, da der Encoder immer oberhalb des Teils W und damit oberhalb des Tool Center Point TCP liegen wird.

Selbstverständlich können im Rahmen dieser Erfindung die verschiedenen Elemente der Ausführungsformen in unterschiedlicher Weise kombiniert werden.

Statt der 1Dplus-Encoder können auch zweidimensional messende Kreuzgitterencoder verwendet werden, die ebenfalls eine zweidimensionale Positionserfassung ermöglichen. Für die hier beschriebenen Anwendungen benötigt man keine großflächigen Kreuzgitter, sondern solche, die nur in einer Richtung ausgedehnt sind, und quer zu dieser Richtung nur einen kleinen Messbereich ermöglichen. Man kann sich so ein Kreuzgitter als einen 1Dplus Maßstab gemäß Figur 2 vorstellen, dessen beiden Teilungsspuren $T_L$ und $T_T$ ineinandergeschoben oder übereinandergelegt sind. Solche Kreuzgitter sind wesentlich weniger aufwändig in der Herstellung als die eingangs erwähnten großflächigen Kreuzgitter. Im Sinne dieser Anmeldung seinen von dem Begriff 1Dplus Encoder auch Encoder mit solchen Kreuzgittern umfasst.

Neben einem ortsfesten TCP (Ausführungsbeispiele 1,2,3 und 5) und einem mit dem Objekt O mit bewegten TCP (Ausführungsbeispiel 4) gibt es noch die Möglichkeit, dass der TCP sich sowohl zum Referenzobjekt B als auch zum Objekt O bewegt. Grundsätzlich kann die erfindungsgemäße Lagebestimmung gemäß Gleichungen 10 - 12 auch für diesen Fall eingesetzt werden.

Um die Einflüsse von Maschinenvibrationen zu minimieren, die entweder vom Maschinenfundament oder aber durch die Beschleunigungskräfte eingeleitet werden, ist es vorteilhaft die Abtastköpfe an Knotenpunkten von störenden Schwingungsmoden der zugehörigen Messrahmenelemente zu plazieren. Dadurch wird die Übertragung der Maschinenvibration auf die Abtastköpfe minimiert und die Messgenauigkeit erhöht.

Darüberhinaus können verschiedene Entkopplungselemente $E_{B'-B,n}$, $E_{F'-F,n}$ und $E_{O'-O,n}$ zwischen den Messrahmenelementen B, F, O und den zugehörigen Kraftrahmenelementen B', F', O' eingesetzt werden. Neben Festkörperelementen sind auch mechanische Berührkontakte wie z.B. Kugeln, die durch Federn gegen Nuten gedrückt werden, verwendbar. Lorentzaktuatoren bieten besondere Vorteile, da sie neben einer sehr guten Schwingungsisolierung auch eine zusätzliche Verstellung ermöglichen.

Um nicht nur eine sehr hohe Reproduzierbarkeit sondern auch eine sehr hohe Genauigkeit der erfindungsgemäße Lagebestimmung des Objektes O erreichen zu können, muss diese kalibriert werden. Aus der Literatur sind dazu verschiedene Kalibrierverfahren bekannt.

In allen Ausführungsformen kann statt den zwei, jeweils parallel angeordneten Maßstäben auch nur ein 1Dplus Maßstab verwendet werden, der dann aber wie im dritten Ausführungsbeispiel durch drei Abtastköpfe abgetastet werden muss. Zwei der drei Abtastköpfe tasten dabei die Querteilung $T_T$ ab. Der Abstand dieser beiden Abtastköpfe sollte möglichst groß sein, um eine ausreichende Genauigkeit für die Bestimmung der entsprechenden Rotation Rz zu erzielen.

Um in Z-Richtung den effektiven Messpunkt des Encoders in die gleiche Höhe wie das Messobjekt zu bringen, muss ein Teil des Encoders in Z-Richtung über das Messobjekt hinausragen. Die Vermeidung eines Zusammenstoßes mit dem Werkzeug ist damit schwierig zu erreichen. Deshalb kann es vorteilhaft sein, die Komponenten des Encoders in Z-Richtung soweit nach unten zu verschieben, dass sie nicht mehr über das Messobjekt hinausragen. Der dadurch entstehende Abbe-Abstand von ca. 20mm ist in vielen Fällen noch akzeptabel.

Typische Führungsfehler für Linearführungen betragen etwa 1 - 10 Mikrorad. Ein Abbe Abstand in Z-Richtung von 10 Millimetern führt dann zu einem Messfehler zwischen 10 und 100 Nanometer. Betrachtet man 100 Nanometer als noch zulässigen Messfehler, so darf der Abbe Abstand höchstens 10 Millimeter betragen.

**Patentansprüche**

**1.** XY-Tisch mit einem Werkzeug (TL) und einer Messanordnung zur Positionsbestimmung,

- mit einem ortsfesten Referenzteil (B) und einem Zwischenteil (F), das relativ zum Referenzteil (B) in einer ersten Richtung (Y) verschiebbar gehalten ist,
- mit einem Objekt (O) das relativ zum Zwischenteil (F) in einer zweiten Richtung (X) verschiebbar gehalten ist,
- wobei ein mit dem Werkzeug (TL) zu bearbeitendes Teil (W) auf dem Objekt (O) oder auf dem Referenzteil (B) angeordnet ist,
- sowie für die erste Richtung (Y) mit wenigstens einem 1 Dplus-Encoder (M1, M2) mit einem Maßstab (M, M1, M2, M3, M4), der eine Längsspur ($T_L$) zur Positionsmessung in der ersten Richtung (Y) und eine Querspur ($T_T$) zur Positionsmessung in der zweiten Richtung (X) aufweist, geeignet zum Messen zweier linearer und eines rotatorischen Freiheitsgrades (X, Y, Rz) von in einer durch die erste und zweite Richtung (X, Y) aufgespannten Ebene möglichen Bewegungen zwischen Referenzteil (B) und Zwischenteil (F),
- und für die zweite Richtung (X) mit wenigstens einem weiteren 1Dplus-Encoder (M3, M4) mit einem weiteren Maßstab (M), der eine Längsspur ($T_L$) zur Positionsmessung in der zweiten Richtung (X) und eine Querspur ($T_T$) zur Positionsmessung in der ersten Richtung (Y) aufweist, geeignet zum Messen der besagten Freiheitsgrade (X, Y, Rz) zwischen dem Objekt (O) und dem Zwischenteil (F),
- so dass die Lage eines Tool Center Points (TCP) am Teil (W) durch diese 1Dplus-Encoder (M1, M2) erfassbar ist, wobei der Tool Center Point (TCP) der vom Werkzeug (TL) im Gebrauch erfasste Punkt des Teils (W) ist,

**dadurch gekennzeichnet, dass**

- die 1Dplus-Encoder (M1, M2, M3, M4) konstruktiv so angeordnet sind, dass deren Projektion in die durch die erste und zweite Richtung (Y, X) aufgespannte Ebene, die den Tool Center Point (TCP) enthält, im gesamten Verfahrbereich des XY-Tisches außerhalb des Teils (W) liegt.

2. XY-Tisch nach Anspruch 1, **dadurch gekennzeichnet, dass** die 1Dplus-Encoder (M1, M2, M3, M4) so angeordnet sind, dass deren effektive Messorte bezüglich einer dritten Richtung (Z) senkrecht zur ersten und zweiten Richtung (Y, X) im Wesentlichen auf gleicher Höhe liegen.

3. XY-Tisch nach Anspruch 2, **dadurch gekennzeichnet, dass** die 1 Dplus-Encoder (M1, M2, M3, M4) so angeordnet sind, dass deren effektive Messorte und der Tool Center Point (TCP) bezüglich der dritten Richtung (Z) im Wesentlichen auf gleicher Höhe liegen.

4. XY-Tisch nach Anspruch 2 oder 3, **dadurch gekennzeichnet, dass** die 1Dplus-Encoder (M1, M2, M3, M4) so angeordnet sind, dass deren effektive Messorte bezüglich der dritten Richtung (Z) um nicht mehr als zehn Millimeter vom Tool Center Point (TCP) entfernt sind.

5. XY-Tisch nach einem der vorhergehenden Ansprüche, **dadurch gekennzeichnet, dass** für die erste und/oder zweite Richtung (Y, X) auf zwei gegenüberliegenden Seiten des Teils (W) je ein durch zwei Abtastköpfe ($AK_{X1}$, $AK_{Y1}$, $AK_{X2}$, $AK_{Y2}$, $AK_{X3}$, $AK_{Y3}$, $AK_{X4}$, $AK_{Y4}$) abgetasteter 1Dplus-Encoder (M1, M2, M3, M4) liegt, der jeweils an einem der Elemente Referenzteil (B), Zwischenteil (F) und Objekt (O) befestigt ist.

6. XY-Tisch nach einem der vorhergehenden Ansprüche, **dadurch gekennzeichnet, dass** für die erste und/oder zweite Richtung (Y, X) ein durch drei Abtastköpfe ($AK_{X3}$, $AK_{Y3}$, $AK_{Y4}$) abgetasteter 1Dplus-Encoder (M3) vorgesehen ist, der an einem der Elemente Referenzteil (B), Zwischenteil (F) und Objekt (O) befestigt ist.

7. XY-Tisch nach einem der vorhergehenden Ansprüche, **dadurch gekennzeichnet, dass** sich Referenzteil und/oder Zwischenteil und/Oder Objekt jeweils zusammensetzen aus einem Komponenten der 1Dplus-Encoder (M1, M2, M3, M4, AK) tragenden Messrahmenelement (B, F, O) und einem Kraft erzeugende Elemente tragenden Kraftrahmenelement (B', F', O').

8. XY-Tisch nach Anspruch 7, **dadurch gekennzeichnet, dass** die Kraftrahmenelemente (B', F', O') vom jeweiligen Messrahmenelement (B, F, O) durch Entkopplungselemente ($E_{B'-B,n}$, $E_{F'-F,n}$, $E_{O'-O,n}$) getrennt sind.

9. XY-Tisch nach Anspruch 8, **dadurch gekennzeichnet, dass** die Entkopplungselemente ($E_{B'-B,n}$, $E_{F'-F,n}$, $E_{O'-O,n}$) eine kinematische Verbindung zwischen den jeweiligen Kraftelementen (B', F', O') und Messrahmenelementen (B, F, O) herstellen.

10. XY-Tisch nach einem der vorhergehenden Ansprüche, **dadurch gekennzeichnet, dass** einer der Maßstäbe (M3) in einer mittleren Lage des Objekts (O) redundant von zwei voneinander beabstandeten Paaren von Abtastköpfen ($AK_{X3a}/AK_{Y3a}$, $AK_{X3b}/AK_{Y3b}$) und in äußeren Lagen nur von jeweils einem der Paare abgetastet wird, so dass ein Messbereich auf einen Wert vergrößert ist, der größer ist als die Länge des Maßstabes (M3).

11. XY-Tisch nach Anspruch 10, **dadurch gekennzeichnet, dass** ein Abstand der beiden Paare von Abtastköpfen ($AK_{X3a}/AK_{Y3a}$, $AK_{X3b}/AK_{Y3b}$) größer ist als die Ausdehnung eines Werkzeugs (TL), so dass eine Kollision der Abtastköpfe ($AK_{X3a}/AK_{Y3a}$, $AK_{X3b}/AK_{Y3b}$) mit dem Werkzeug (TL) in jeder möglichen Lage des Objekts (O) ausgeschlossen ist.

12. XY-Tisch nach einem der vorhergehenden Ansprüche, **dadurch gekennzeichnet, dass** Teilungsstrukturen ($T_L$, $T_T$) der Maßstäbe (M, M1, M2, M3, M4) senkrecht und parallel zur Messrichtung (X) verlaufen.

13. XY-Tisch nach einem der Ansprüche 1-12, **dadurch gekennzeichnet, dass** die Maßstäbe (M) Teilungsstrukturen ($T_\alpha$, $T_\beta$) aufweisen, die in unterschiedlichen Winkeln ($\alpha,\beta$) zur Messrichtung (X) geneigt sind.

14. XY-Tisch nach Anspruch 12 oder 13, **dadurch gekennzeichnet, dass** die Teilungsstrukturen nach Art eines Kreuzgitters übereinander angeordnet sind.

15. XY-Tisch nach einem der vorhergehenden Ansprüche, **dadurch gekennzeichnet, dass** Positionen durch sich gegenüberliegende Abtastköpfe ($AK_{Y1}$, $AK_{Y2}$) redundant erfasst werden, um die thermische Ausdehnungen zu korrigieren.

## Claims

1. XY table having a tool (TL) and a measuring arrangement for position determination,

   - having a fixed reference part (B) and an intermediate part (F), which is mounted so it is displaceable in relation to the reference part (B) in a first direction (Y),
   - having an object (O) which is mounted so it is displaceable in relation to the intermediate part (F) in a second direction (X),
   - wherein a part (W) to be processed using the tool (TL) is arranged on the object (O) or on the reference part (B),
   - and also having at least one 1Dplus encoder ($M_1$, $M_2$) for the first direction (Y), having a measuring standard (M, $M_1$, $M_2$, $M_3$, $M_4$), which has a longitudinal track ($T_L$) for position measurement in the first direction (Y) and a transverse track ($T_T$) for position measurement in the second direction (X), suitable for measuring two linear and one rotational degree of freedom (X, Y, Rz) of possible movements between reference part (B) and intermediate part (F) in a plane spanned by the first and second directions (X, Y),
   - and having at least one further 1Dplus encoder ($M_3$, $M_4$) for the second direction (X), having a further measuring standard (M), which has a longitudinal track ($T_L$) for position measurement in the second direction (X) and a transverse track ($T_T$) for position measurement in the first direction (Y), suitable for measuring said degrees of freedom (X, Y, Rz) between the object (O) and the intermediate part (F),
   - so that the location of a tool centre point (TCP) on the part (W) is detectable by this 1Dplus encoder ($M_1$, $M_2$), wherein the tool centre point (TCP) is the point of the part (W) detected by the tool ($T_L$) in use,

   **characterized in that**

   - the 1Dplus encoders ($M_1$, $M_2$, $M_3$, $M_4$) are structurally arranged so that the projection thereof in the plane spanned by the first and second directions (Y, X), which contains the tool centre point (TCP) is located outside the part (W) in the entire movement range of the XY table.

2. XY table according to Claim 1, **characterized in that** the 1Dplus encoders ($M_1$, $M_2$, $M_3$, $M_4$) are arranged so that the effective measuring locations thereof with respect to a third direction (Z) perpendicularly in relation to the first and second directions (Y, X) are located at substantially equal height.

3. XY table according to Claim 2, **characterized in that** the 1Dplus encoders ($M_1$, $M_2$, $M_3$, $M_4$) are arranged so that the effective measuring locations thereof and the tool centre point (TCP) are located at substantially equal height with respect to the third direction (Z).

4. XY table according to Claim 2 or 3, **characterized in that** the 1Dplus encoders ($M_1$, $M_2$, $M_3$, $M_4$) are arranged so that the effective measuring locations thereof are not more than 10 mm away from the tool centre point (TCP) with respect to the third direction (Z).

5. XY table according to any one of the preceding claims, **characterized in that** a 1Dplus encoder ($M_1$, $M_2$, $M_3$, $M_4$), which is scanned by two scanning heads ($AK_{X1}$, $AK_{Y1}$, $AK_{X2}$, $AK_{Y2}$, $AK_{X3}$, $AK_{Y3}$, $AK_{X4}$, $AK_{Y4}$), and which is fastened in each case to one of the elements reference part (B), intermediate part (F), and object (O), is located on two opposing sides of the part (W) for the first and/or second directions (Y, X).

6. XY table according to any one of the preceding claims, **characterized in that** a 1Dplus encoder ($M_3$), which is scanned by three scanning heads ($AK_{X3}$, $AK_{Y3}$, $AK_{Y4}$), and which is fastened on one of the elements reference part (B), intermediate part (F), and object (O), is provided for the first and/or second directions (Y, X).

7. XY table according to any one of the preceding claims, **characterized in that** the reference part and/or intermediate part and/or object are each composed of a component of the measuring frame element (B, F, O) carrying the 1Dplus encoders ($M_1$, $M_2$, $M_3$, $M_4$, AK) and a force frame element (B', F', O') carrying force generating elements.

8. XY table according to Claim 7, **characterized in that** the force frame elements (B', F', O') are separated from the respective measuring frame element (B, F, O) by decoupling elements ($E_{B'-B,n}$, $E_{F'-F,n}$, $E_{O'-O,n}$).

9. XY table according to Claim 8, **characterized in that** the decoupling elements ($E_{B'-B,n}$, $E_{F'-F,n}$, $E_{O'-O,n}$) produce a kinematic connection between the respective force elements (B', F', O') and measuring frame elements (B, F, O).

10. XY table according to any one of the preceding claims, **characterized in that** one of the measuring standards ($M_3$) is scanned in a middle location of the object (O) redundantly by two pairs of scanning heads ($AK_{X3a}/AK_{Y3a}$, $AK_{X3b}/AK_{Y3b}$) and in outer locations is only scanned by one of the pairs, so that a measuring range is enlarged to a value which is greater than the length of the measuring standard ($M_3$).

11. XY table according to Claim 10, **characterized in that** a distance of the two pairs of scanning heads ($AK_{X3a}/AK_{Y3a}$, $AK_{X3b}/AK_{Y3b}$) is greater than the extension of a tool ($T_L$), so that a collision of the scanning heads ($AK_{X3a}/AK_{Y3a}$, $AK_{X3b}/AK_{Y3b}$) with the tool ($T_L$) is precluded in any possible location of the object (0).

12. XY table according to any one of the preceding claims, **characterized in that** division structures ($T_L$, $T_T$) of the measuring standards (M, $M_1$, $M_2$, $M_3$, $M_4$) extend perpendicularly and in parallel to the measuring direction (X).

13. XY table according to any one of claims 1 to 12, **characterized in that** the measuring standards (M) have division structures ($T_\alpha$, $T_\beta$) which are inclined at different angles ($\alpha$, $\beta$) in relation to the measuring direction (X).

14. XY table according to Claim 12 or 13, **characterized in that** the division structures are arranged one over another like a cross grid.

15. XY table according to any one of the preceding claims, **characterized in that** positions are redundantly detected by opposing scanning heads ($AK_{Y1}$, $AK_{Y2}$) to correct for thermal expansions.

**Revendications**

1. Table XY présentant un outil (TL) et un ensemble de mesure pour la détermination de position,

- avec une partie fixe de référence (B) et une partie intermédiaire (F) maintenue à coulissement dans une première direction (Y) par rapport à la partie de référence (B),
- avec un objet (O) maintenu à coulissement dans une deuxième direction (X) par rapport à la partie intermédiaire (F),
- une pièce (W) à traiter par l'outil (TL) étant disposée sur l'objet (0) ou sur la partie de référence (B),
- avec dans la première direction (Y), au moins un encodeur 1Dplus (M1, M2) présentant une échelle (M, M1, M2, M3, M4) qui présente une piste longitudinale ($T_L$) pour la mesure de position de la première direction (Y) et une piste transversale ($T_T$) pour la mesure de position dans la deuxième direction (X), convenant pour mesurer deux degrés de liberté linéaire et un degré de liberté en rotation (X, Y, Rz) de déplacement possible entre la partie de référence (B) et la partie intermédiaire (F) dans un plan sous-tendu par la première et la deuxième direction (X, Y),
- et avec dans la deuxième direction (X), au moins un autre encodeur 1Dplus (M3, M4) présentant une autre échelle de mesure (M) qui présente une piste longitudinale ($T_L$) pour la mesure de position dans la deuxième direction (X) et une piste transversale ($T_T$) pour la mesure de position de la première direction (Y), convenant pour mesurer lesdits degrés de liberté (X, Y, Rz) entre l'objet (0) et la partie intermédiaire (F),
- de telle sorte que la position d'un point central d'outil (TCP) sur la pièce (W) puisse être saisie par ces encodeurs 1Dplus (M1, M2), le point central d'outil (TCP) étant le point de la pièce (W) engagé en utilisation par l'outil (TL),

**caractérisée en ce que**

- les encodeurs 1Dplus (M1, M2, M3, L4) sont structurellement disposés de telle sorte que leur projection dans le plan sous-tendu par la première et la deuxième direction (Y, X) qui contient le point central d'outil (TCP) est située au-dessus de la pièce (W) dans toute la plage de déplacement de la table XY.

2. Table XY selon la revendication 1, **caractérisée en ce que** les encodeurs 1Dplus (M1, M2, M3, M4) sont disposés de telle sorte que leurs emplacements effectifs de mesure dans une troisième direction (Z) perpendiculaire à la première et à la deuxième direction (Y, X) sont situés essentiellement à même hauteur.

3. Table XY selon la revendication 2, **caractérisée en ce que** les encodeurs 1Dplus (M1, M2, M3, M4) sont disposés de telle sorte que leurs emplacements effectifs de mesure et le point central d'outil (TCP) sont situés essentiellement à même hauteur dans la troisième direction (Z).

4. Table XY selon les revendications 2 ou 3, **caractérisée en ce que** les encodeurs 1Dplus (M1, M2, M3, M4) sont disposés de telle sorte que leurs emplacements de mesure effectifs soient éloignés dans la troisième direction (Z) d'au plus dix millimètres du point central d'outil (TCP).

5. Table XY selon l'une des revendications précédentes, **caractérisée en ce que** pour la première et/ou la deuxième direction (Y, X), sur chacun des deux côtés opposés de la pièce (W) est situé un encodeur 1Dplus (M1, M2, M3, M4) palpé par deux têtes de palpage ($AK_{X1}$, $AK_{Y1}$, $AK_{X2}$, $AK_{Y2}$, $AK_{X3}$, $AK_{Y3}$, $AK_{X4}$, $AK_{Y4}$), chaque encodeur étant fixé sur l'un des éléments partie de référence (B), partie intermédiaire (F) ou objet (0).

6. Table XY selon l'une des revendications précédentes, **caractérisée en ce que** pour la première et/ou la deuxième direction (Y, X), un encodeur 1Dplus (M3) palpé par trois têtes de palpage ($AK_{X3}$, $AK_{Y3}$, $AK_{Y4}$) est prévu et est fixé sur l'un des éléments partie de référence (B), partie intermédiaire (F) ou objet (0).

7. Table XY selon l'une des revendications précédentes, **caractérisée en ce que** la partie de référence, la partie intermédiaire et/ou l'objet sont chacun composé d'un élément (B, F, 0) du cadre de mesure portant des composants des encodeurs 1Dplus (M1, M2, M3, M4, AK) et un élément (B', F', O') du cadre dynamique qui porte des éléments impliquant une force.

8. Table XY selon la revendication 7, **caractérisée en ce que** les éléments (B', F', O') du cadre dynamique sont séparés par des éléments de désaccouplement ($E_{B'-B,n}$, $E_{F'-F,n}$, $E_{O'-O,n}$) de chaque élément (B, F, O) du cadre de mesure.

9. Table XY selon la revendication 8, **caractérisée en ce que** les éléments de désaccouplement ($E_{B'-B,n}$, $E_{F'-F,n}$, $E_{O'-O,n}$) établissent une liaison cinématique entre chacun des éléments dynamiques (B', F', O') et des éléments (B, F, 0) du cadre de mesure.

10. Table XY selon l'une des revendications précédentes, **caractérisée en ce que** l'une des échelles de mesure (M3) est palpée dans une position centrale de l'objet (O) de manière redondante par deux paires, maintenues à distance l'une de l'autre, de têtes de palpage ($AK_{X3a}$/$AK_{Y3a}$, $AK_{X3b}$/$AK_{Y3b}$) et dans des positions extérieures, par seulement une des paires, de sorte qu'une plage de mesure est agrandie d'une valeur supérieure à la longueur de l'échelle de mesure (M3).

11. Table XY selon la revendication 10, **caractérisée en ce que** la distance entre les deux paires de têtes de palpage ($AK_{X3a}$/$AK_{Y3a}$, $AK_{X3b}$/$AK_{Y3b}$) est plus grande que l'extension d'un outil (TL), de sorte qu'une collision entre les têtes de palpage ($AK_{X3a}$/$AK_{Y3a}$, $AK_{X3b}$/$AK_{Y3b}$) avec l'outil (TL) soit exclue quelle que soit la position de l'objet (O).

12. Table XY selon l'une des revendications précédentes, **caractérisée en ce que** des structures de division ($T_L$, $T_T$) des échelles de mesure (M, M1, M2, M3, M4) s'étendent perpendiculairement et parallèlement à la direction de mesure (X).

13. Table XY selon l'une des revendications 1 à 12, **caractérisée en ce que** les échelles de mesure (M) présentent des structures de division ($T_\alpha$, $T_\beta$) qui sont inclinées par rapport à la direction de mesure (X) sous des angles ($\alpha$, $\beta$) différents.

14. Table XY selon les revendications 12 ou 13, **caractérisée en ce que** les structures de division sont disposées les unes au-dessus des autres à la manière d'une grille en croix.

15. Table XY selon l'une des revendications précédentes, **caractérisée en ce que** les positions sont saisies de manière redondante par des têtes de palpage ($AK_{Y1}$, $AK_{Y2}$) mutuellement opposées, pour corriger les dilatations thermiques.

EP 2 247 915 B1

FIG. 1

FIG. 2

15

FIG. 3

FIG. 4

FIG. 5

FIG. 6

FIG. 7a

EP 2 247 915 B1

## FIG. 7b

## FIG. 7c

FIG. 8

FIG. 9

FIG. 10

EP 2 247 915 B1

FIG. 11

EP 2 247 915 B1

FIG. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1762828 A2
- DE 102006024579 A1
- US 6949733 B2
- US 4587622 A
- US 20030053037 A1
- DE 102005023984 A1
- US 4758720 A